# EUROPEAN PATENT APPLICATION

(11) **EP 4 746 296 A1**
(43) Date of publication of application: **20.05.2026**
(21) Application number: 24212943.5
(22) Date of filing: 14.11.2024
(51) Int. Cl.: H03K 17/0812, H02H 3/08, H03K 17/10, H03K 17/12

(54) **ELECTRIC SWITCHING SYSTEM AND OPERATING METHOD**

(71) Applicant: Hitachi Energy Ltd, 8050 Zürich (CH)
(72) Inventor: Nakamura, Tetsuya, 78 454 Borlänge (SE); Liljekvist, Jim, 79 134 Falun (SE)
(74) Representative: Epping - Hermann - Fischer

(57) **Abstract**

In one embodiment, the electric switching system (1) comprises semiconductor switches (41, 42, 43) and a control unit (3), wherein
- the semiconductor switches (41, 42, 43) each comprise a transistor structure (51) and a diode structure (52) being electrically connected in anti-parallel with each other,
- the semiconductor switches (41, 42, 43) are arranged in a first branch (21) being a series connection of first semiconductor switches (41, 43) and in a second branch (22) being a series connection of second semiconductor switches (42), the first branch (21) being electrically connected in parallel with the second branch (22), and
- in case that a defective one (43) of the first semiconductor switches (41, 43) is in a short-circuit failure mode, the control unit (3) turns on remaining working ones (41) of the first semiconductor switches (41, 43) during a reverse current flow direction phase.

## Description

An electric switching system is provided. An operating method for such an electric switching system is also provided.

Documents WO 2024/141213 A1, WO 2024/141239 A1, US 2011/0136300 A1 and EP 2 249 392 A2 refer to bi-mode insulated gate transistors.

Documents US 2006/0071280 A1 and EP 0 600 241 A2 refer to metal oxide semiconductor-controlled diodes.

Document WO 2017/157440 A1 refers to a hybrid high-voltage direct current breaker using a load commutation switch.

A problem to be solved is to provide an electric switching system that has improved behavior in case of a defective semiconductor switch.

This object is achieved, inter alia, by an electric switching system and by an operating method as defined in the independent claims. Exemplary further developments constitute the subject-matter of the dependent claims.

For example, the electric switching system comprises semiconductor switches and a control unit. The semiconductor switches each have a transistor structure and a diode structure electrically connected in anti-parallel, a behavior of the diode structure depending on a gate voltage of the transistor structure. In case that in one of a plurality of series connections of the semiconductor switches there is a shorted one of the semiconductor switches, remaining working ones of the semiconductor switches of the respective series connection are turned on during a reverse current flow direction phase.

Thus, a load commutation switch, LCS, branch current sharing scheme is provided. Especially, a bi-mode insulated gate transistor, BIGT, control method to increase LCS lifetime in case of a failed BIGT is provided. For example, the electric switching system and the method described herein are applied to an LCS in a hybrid high-voltage direct current breaker, for short hybrid HVDC breaker or HHB.

Hence, in the electric switching system described herein, a modified control code in, for example, a valve control unit, VCU, is provided. The control code detects when the main current flows in a reverse direction and reacts by turning on the BIGTs in the failed branch. This concept can also be applied in any other electrical circuit with parallel branches of series-connected semiconductor switches like BIGTs, and where the switches are supposed to fail in short-circuit failure mode, SCFM.

With the system and method described herein, an increased lifetime of, for example, an LCS circuit in case of a failed switch, like a BIGT, can be achieved.

In at least one embodiment, the electric switching system comprises a plurality of semiconductor switches and a control unit, wherein
- the semiconductor switches each comprise a transistor structure and a diode structure being electrically connected in anti-parallel with each other,
- the semiconductor switches are arranged in a first branch being a series connection of first ones of the semiconductor switches and in a second branch being a series connection of second ones of the semiconductor switches, the first branch being electrically connected in parallel with the second branch, and
- in case that a defective one of the first ones of the semiconductor switches is in a short-circuit failure mode, SCFM, the control unit is configured to turn on remaining working ones of the first ones of the semiconductor switches during a reverse current flow direction phase of the electric switching system.

SCFM means, for example, that upon a defect the device behaves like an electric short, that is, its electrical resistance drops to virtually zero. For a semiconductor switch having in its intended operation both a conductive on-state and a blocking off-state, this means that in case of a defect of the semiconductor switch it is always in the conductive on-state. For gate-controlled transistor structures this may mean that independent of a gate voltage the transistor structure is always conductive. For example, an SCFM may be a typical failure case for transistor structures. In other words, the semiconductor switches could be devices that show the SCFM, and upon occurrence of the SCFM they are always in an on-state. An alternative to an SCFM is that the respective device falls into an open circuit mode, which means that it has a very high electric resistance.

For example, the control unit is a valve control unit, VCU. The control unit may be implemented as a voltage source controlled by a microprocessor. It is possible that each gate electrode of the semiconductor switches is individually controllable by the control unit. Thus, a number of output lines of the control unit may correspond to or may be at least an overall number of the semiconductor switches.

According to at least one embodiment, the transistor structure and a diode structure are embodied in a single semiconductor body. In other words, the transistor structure and the diode structure can be within the same semiconductor layer sequence and/or within the same semiconductor chip. Otherwise, the transistor structure and the diode structure may be implemented in two different semiconductor chips or semiconductor devices put electrically in parallel by means of an electric wiring which is, for example, outside the respective semiconductor chips or semiconductor devices.

According to at least one embodiment, all the semiconductor switches are of a same type, for example, are nominally identical in construction. Otherwise, different types of semiconductor switches may be combined with one another in the electric switching system.

According to at least one embodiment, one, some, most of or all the semiconductor switches are bi-mode insulated gate transistors, BIGTs.

According to at least one embodiment, one, some, most of or all the semiconductor switches are metal oxide semiconductor-controlled diodes, also referred to as MOS-controlled diodes or MCDs.

In case of BIGTs or MCDs the transistor structure and the diode structure may be implemented in a single semiconductor layer sequence and/or semiconductor body.

For example, the BIGT is essentially a high voltage, high current transistor with an integrated anti-parallel diode. This means that it can be used as a controlled current switch by applying a certain voltage between two of its three electrical terminals, namely a gate electrode and an emitter electrode; this voltage can be referred to as Vge. If Vge is 0 V or lower, the BIGT is said to be turned off, meaning it prevents current from flowing in a forward direction. If Vge is higher, say 15 V, the BIGT is said to be turned on, meaning it allows current to flow in a forward direction. As there is an integrated anti-parallel diode in the BIGT, current flowing in the reverse direction cannot be turned off.

However, a voltage drop of the diode depends on Vge, and it is this effect that may be used in the electric switching system described herein. By increasing the Vge, the voltage drop in the diode increases, whereas a reduced Vge reduces said voltage drop. So, if current is flowing in the reverse direction, typically one would reduce the Vge to reduce the voltage drop and hence also reduce the losses. In the electric switching system described herein, for parallelly connected semiconductor switches, this effect can be used in the opposite way, by increasing Vge, and thus increasing voltage drop, to redirect current from faulty branches.

According to at least one embodiment, during the reverse current flow direction phase, a voltage drop over the first branch is higher than over the second branch. Thus, current flow occurs mostly through the at least one second branch and current flow through the first branch is reduced.

According to at least one embodiment, during a forward current flow direction phase of the electric switching system, the control unit is configured to turn off the working ones of the first ones of the semiconductor switches. Thus, also during the forward phase, current flow through the first branch is prevented. It is thus possible that the working ones of the first semiconductor switches may be controlled in the opposite manner than the second semiconductor switches: if the former are turned on, the latter are turned off, and vice versa.

Otherwise, it is possible that current flow through the first branch is allowed during the forward current flow direction phase, which means that all the working ones of the semiconductor switches may be turned on, and that current may flow both through the first and second branches. Hence, just the second semiconductor switches may cyclically be switched while the working ones of the first semiconductor switches may most of the time or may always be in the on-state.

According to at least one embodiment, the first branch has a same number of the semiconductor switches as the second branch. This may apply to all the second branches if there is more than one second branch. For example, all the branches have the same number of the semiconductor switches, and all the semiconductor switches are optionally of the same type.

According to at least one embodiment, the first branch comprises at least three or at least five of the first ones of the semiconductor switches. Alternatively or additionally, the first branch comprises at most 30 or at most 20 or at most ten of the first ones of the semiconductor switches. The same may apply to the second branch or, in the case of more than one second branch, for one, some of or all the second branches.

For example, an overall number of the branches, that is, first branches and second branches together, is at least two or is at least three or is at least four. Alternatively or additionally, said number is at most 20 or at most ten or at most six. Especially, there are at least three and at most six of the branches. For example, there are at least two and at most ten or at most six of the second branches.

According to at least one embodiment, all the second ones of the semiconductor switches are working ones. In other words, in the at least one second branch there is no defective semiconductor switch being in the SCFM, for example.

According to at least one embodiment, a first threshold voltage of the semiconductor switches in a transistor mode is higher than a second threshold voltage of the semiconductor switches in a diode mode except for the defective one of the first ones of the semiconductor switches being in the SCFM. Hence, an effective electric resistance of the semiconductor switches can be higher in the transistor mode than in the diode mode, that is, can be higher in the forward direction than in the reverse direction.

According to at least one embodiment, the first threshold voltage differs from the second threshold voltage by at least a difference factor of 1.2 or of 1.4 or of 1.6. Alternatively or additionally, said difference factor is at most five or is at most 3.0 or is at most 2.2.

According to at least one embodiment, for the first threshold voltage V1, the second threshold voltage V2 and the same number of the semiconductor switches N in all of the first and second branches, the following applies: N > V2/(V2-V1). Using such a number of the semiconductor switches can ensure that current flow through the first branch in case of the SCFM can efficiently be reduced.

According to at least one embodiment, the following applies: N ≥ (V2+X)/(V2-V1) or N = (V2+X)/(V2-V1) with 1.5 V ≤ X ≤ 8 V or with 3 V ≤ X ≤ 6 V. By having X, some safety can be implemented to achieve that current flow through the first branch in case of the SCFM can indeed be reduced.

According to at least one embodiment, the following applies: N ≤ (V2+Y)/(V2-V1) or N = (V2+Y)/(V2-V1) with 8 V ≤ Y ≤ 15 V or with 8 V ≤ X ≤ 10 V. Thus, excessively large numbers of the semiconductor switches per branch can be avoided.

According to at least one embodiment, the electric switching system is a load commutation switch, LCS, or is part of the LCS.

A hybrid high-voltage direct current breaker, HHB, is additionally provided. The HHB includes one or a plurality of the electric switching systems as indicated in connection with at least one of the above-stated embodiments. Features of the electric switching system are therefore also disclosed for the HHB and vice versa.

In at least one embodiment, the HHB comprises a high-voltage input line, a high-voltage output line, and the electric switching system. The electric switching system is electrically connected between the high-voltage input line and the high-voltage output line.

An operating method for the electric switching system is additionally provided. By means of the operating method, an electric switching system as indicated in connection with at least one of the above-stated embodiments is operated. Features of the electric switching system and the HHB are therefore also disclosed for the operating method and vice versa.

In at least one embodiment, the operating method is for an electric switching system and comprises:
when the electric switching system is in the reverse current flow direction phase, turning on, by the control unit, the remaining working ones of the first ones of the semiconductor switches,
wherein the defective one of the first ones of the semiconductor switches is in the SCFM.

An electric switching system, a hybrid high-voltage direct current breaker and an operating method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist understanding.

In the figures:
- Figure 1: is a schematic electric scheme of an exemplary embodiment of an electric switching system described herein,
- Figure 2: are schematic electric schemes of exemplary embodiments of semiconductor switches for electric switching systems described herein,
- Figure 3: is a schematic representation of an exemplary embodiment of a hybrid high-voltage direct current breaker comprising an electric switching system described herein,
- Figure 4: is a schematic block diagram of an exemplary embodiment of an operating method for electric switching systems described herein,
- Figure 5: is a schematic switching and wiring diagram of a modification of an electric switching system,
- Figures 6 and 7: are schematic switching and wiring diagrams of an exemplary embodiment of an electric switching system described herein, and
- Figure 8: is a schematic representation of comparison data between an electric switching system described herein and a modification of an electric switching system.

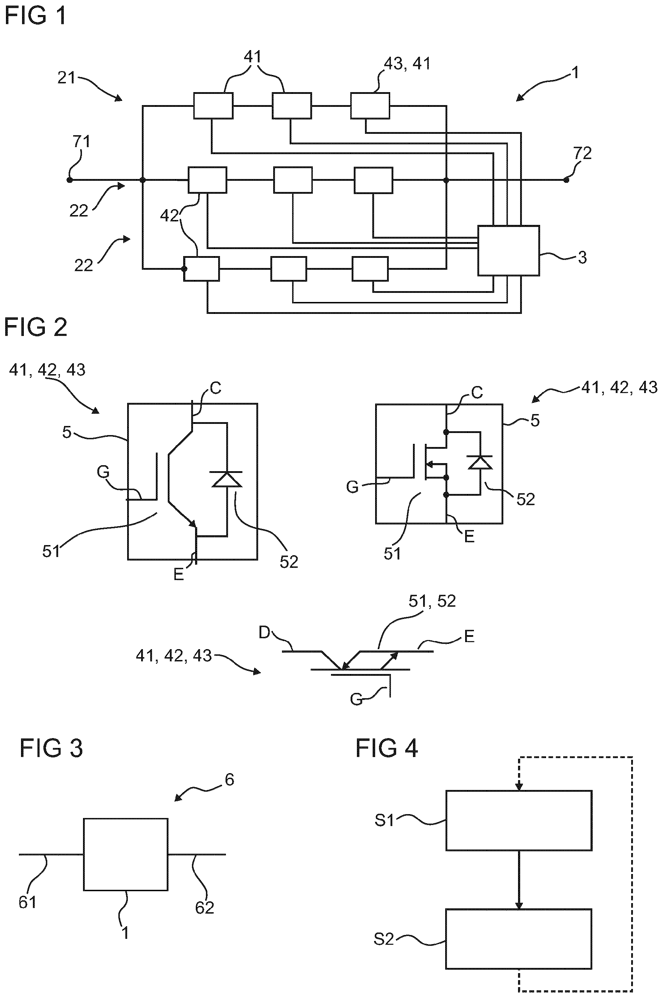

In Figure 1, an example of an electric switching system 1 is illustrated. The electric switching system 1 comprises a first branch 21 and second branches 22 of semiconductor switches 41, 42, 43. Within the respective branch 21, 22, the semiconductor switches 41, 42, 43 are electrically connected in series while the branches 21, 22 are electrically connected in parallel. All the branches 21, 22 may have a common first electric terminal 71 and a common second electric terminal 72. For example, the electric switching system 1 is an LCS.

Each of the branches 21, 22 may comprise a same number of the semiconductor switches 41, 42, 43. It is possible that all the semiconductor switches 41, 42, 43 are of the same type, that is, are of identical construction. Just as an example, there are three of the branches 21, 22, and there are three of the semiconductor switches 41, 42, 43 per branch 21, 22.

Each one of the semiconductor switches 41, 42, 43 has a transistor structure 51 and an anti-parallel diode structure 52, compare also Figure 2. Thus, the semiconductor switches 41, 42, 43 each comprise a gate electrode G, an emitter electrode E and a collector electrode C. Depending on a voltage Vge between the gate electrode G and the emitter electrode E, flow of current between the emitter electrode E and the collector electrode C through the transistor structure 51 is allowed. In case of a turned-off transistor structure 51, current flow may occur through the diode structure 52.

Further, the electric switching system 1 has a control unit 3 which is, for example, a VCU. Each one of the gate electrodes G is connected to the control unit 3. Thus, by means of the control unit 3 the voltages Vge of the semiconductor switches 41, 42, 43 can be controlled individually and independently of one another.

For example, the semiconductor switches 41, 42, 43 are BIGTs. Otherwise, the semiconductor switches 41, 42, 43 could also be MCDs or IGBTs with anti-parallel diodes.

According to Figure 2, left side on the top, the transistor structure 51 is an insulated-gate bipolar transistor, IGBT, structure, and according to Figure 2, right side on the top, the transistor structure 51 is a metal-oxide-semiconductor field-effect transistor, MOSFET, structure. The semiconductor switches 41, 42, 43 can also be based on a BIGT structure, see Figure 2, lower part, as is possible in all the other embodiments, too. The BIGT structure can integrally include both the transistor structure 51 as well as the diode structure 52.

For example, the semiconductor switches 41, 42, 43 each have a semiconductor body 5 which can include a semiconductor layer sequence, not shown. The semiconductor body 5 comprises both the transistor structure 51 and the diode structure 52.

By way of example, in case of BIGTs the semiconductor switches 41, 42, 43 may be implemented as in any one of documents WO 2024/141213 A1, WO 2024/141239 A1, US 2011/0136300 A1 or EP 2 249 392 A2, and in case of MCDs the semiconductor switches 41, 42, 43 may be implemented as in any one of documents US 2006/0071280 A1 or EP 0 600 241 A2; the disclosure content of these documents is incorporated by reference.

Contrary to what is shown in Figure 2 it is likewise possible that the transistor structure 51 and the diode structure 52 are implemented in two different devices or two different chips which are electrically connected in parallel by an external wiring between these chips or devices while according to Figure 2 all the wiring between the transistor structure 51 and the diode structure 52 may be within the semiconductor body 5 and, thus, may be realized by correspondingly doped semiconductor regions, not shown.

The electric switching system 1 is used, for example, in a hybrid high-voltage direct current breaker 6, HHB for short, see Figure 3. The electric switching system 1 is electrically connected between a high-voltage input line 61 and a high-voltage output line 62.

An example of an operating method of the electric switching system 1 is illustrated in Figure 4. In a first method step S1, the electric switching system 1 is turned into an on-state, in which a forward current flows. In a second method step S2 the electric switching system 1 is turned into an off-state, in which a reverse current flows. The method steps S1 and S2 may continuously follow one another in a repeated manner. Optional intermediate steps are not illustrated in Figure 4.

Back to Figure 1, the first branch 21 comprises first ones of the semiconductor switches 41, 43, in the following briefly first switches 41, 43; the second branches 22 comprise second ones of the semiconductor switches 42, in the following briefly second switches 42. The second switches 42 work correctly while the first switches 41, 43 comprise a defective first switch 43 which is in a short-circuit failure mode, SCFM. That is, said switch 43 behaves like an electric short, independent of the voltage Vge. The remaining first switches 41 are working ones like the second switches 42.

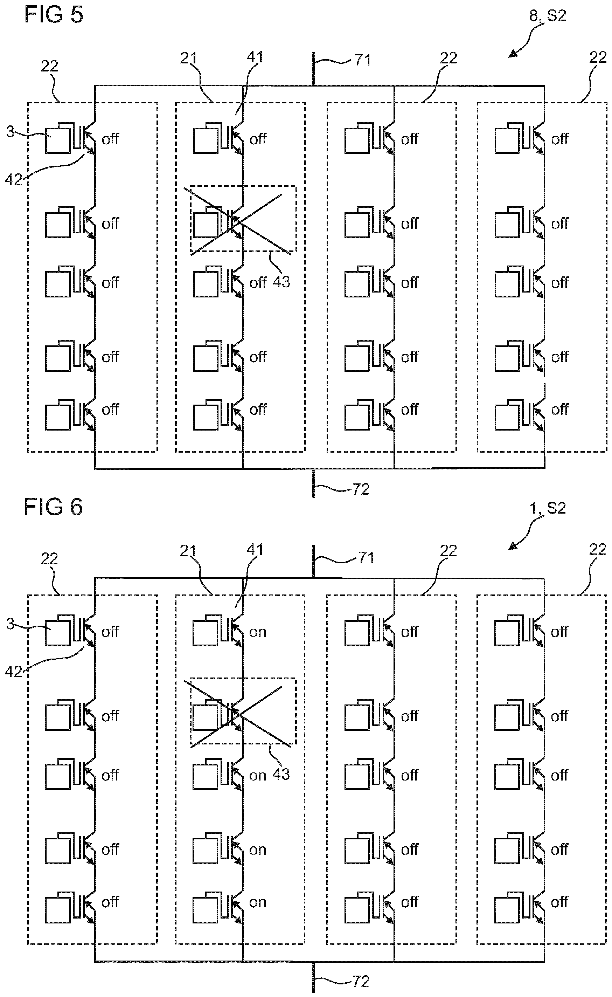

In method step S2, that is, during a reverse current flow direction phase of the electric switching system 1, the second switches 42 are turned off, and the working ones of the first switches 41 are turned on. The transistor unit 51 of the defective one of the first switches 43 is not responsive to any turning on or off. The effect of this switching scheme is explained below in more detail in connection with Figures 5 and 6.

Figure 5 shows a switching scheme of a modification 8 of the electric switching system during the reverse phase. For example, the electric switching system comprises four of the branches 21, 22 with five of the switches 41, 42, 43 each. The example of the electric switching system 1 of Figure 6 has the same structure.

In the case of Figure 5, irrespective of whether there is the SCFM switch 43 or not, all the switches 41, 42, 43 are turned off and on simultaneously, which means that there is no distinction between the first switches 41 and the second switches 42. Contrary to that, according to Figure 6 the working first switches 41 in the first branch 21 comprising the SCFM switch 43 are turned on while the second switches 42 are turned off during the reverse current flow direction phase of the electric switching system 1. This means that for the purpose of this example the electric switching system comprises four parallel branches 21, 22 with five switches 41, 42, 43 connected in series, like BIGTs.

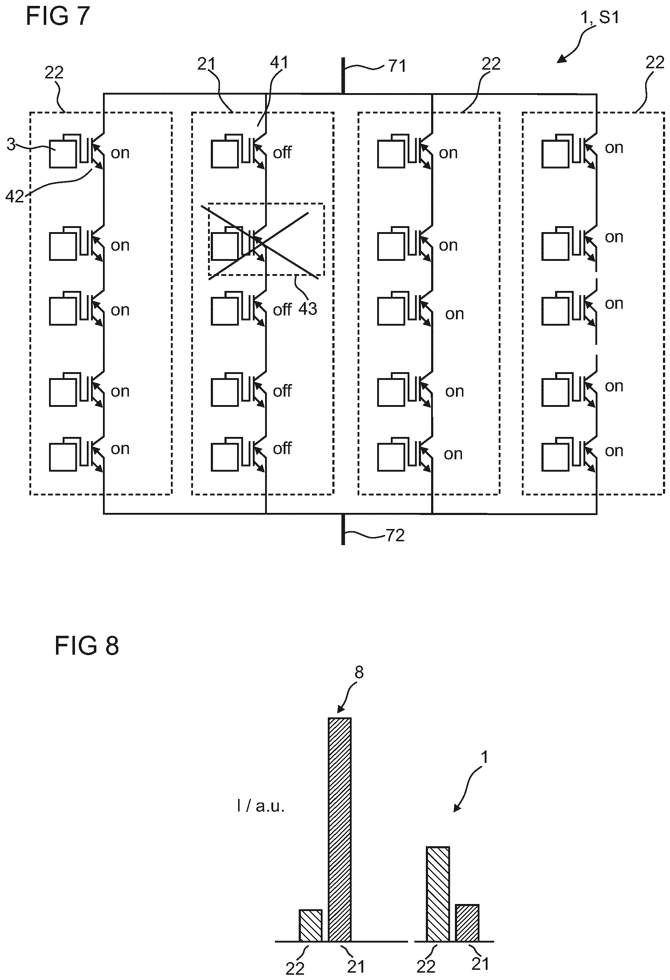

When one of the BIGTs 43 fails, it falls into the Short Circuit Failure Mode, SCFM, and subsequently the remaining BIGTs 41 in the first branch 21 containing said failed BIGT 43 are turned off to force the current to flow through the remaining, healthy branches during the forward current flow direction phase, compare method step S1 of Figure 4 and see Figure 7.

However, in the reverse current flow direction, the current can still flow through the failed branch 21, through the remaining healthy diodes of the first switches 41 and the SCFM switch 43 having the failed BIGT, for example. It is noted that in the reverse current direction, the second switches 42 in the healthy branches 22 are turned off to reduce conduction losses.

Compare Figure 5, the problem is that because of the failed position, a total diode voltage drop is lower in the failed branch 21 than in the healthy branches 22; the former is roughly 4 x 1.35 V = 5.4 V and the latter is roughly 5 x 1.35 V = 6.75 V as the voltage drop per diode is around 1.35 V in this example and as the SCFM switch 43 has virtually a voltage drop of 0 V. It is pointed out that in the situation of Figure 5 the main current in the reverse direction will therefore prefer flowing through the failed branch 21. This can lead to a significant lifetime reduction due to the SCFM switch 43 which might impact busbar dimensioning as well as the dimensions of a cooling system, if present.

In this example, and using typical BIGT according to which the threshold voltage increases when the BIGT is turned on, the proposed solution as descried herein is that in case of the reverse main current direction, when the current would flow through the diodes, the working BIGTs 41 in the failed branch 21 are turned on again as shown in Figure 6. With this, the total voltage drop in the failed branch 21 increases to roughly 4 × 2.5 V = 10 V, assuming a voltage drop of 2.5 V per working first switch 41 and again a voltage drop of virtually 0 V for the defective first switch 43, while in the healthy branches 22 the voltage drop remains at a lower value of roughly 5 × 1.35 V = 6.75 V with about 1.35 V per diode. Therefore, the main current in the reverse direction will prefer flowing through the healthy branches 22 contrary to what is the case in the scenario of Figure 5.

This is further illustrated in Figure 8. In Figure 8, left part, all branches 21, 22 are provided with a voltage Vge of 15 V leading to a voltage drop per working switch 41, 42 of about 2.5 V. This results in a current through the first branch 21 having the SCFM switch 43 being about seven times a current through each one of the three healthy branches 22.

When having the three healthy branches 22 at a voltage Vge of 0 V and the second switches 42 at a voltage Vge of 15 V, then the current through each one of the healthy branches 22 is nearly three times the current through the first branch 21 having the SCFM switch 43.

Hence, with the switching scheme as shown, for example, in Figure 6 the current through the first branch 21 having the SCFM switch 43 can significantly be reduced during the reverse current flow direction phase of the electric switching system 1.

The invention described here is not restricted by the description on the basis of the exemplary embodiments.

Rather, the invention encompasses any new feature and also any combination of features, which includes in particular any combination of features in the patent claims, even if this feature or this combination itself is not explicitly specified in the patent claims or exemplary embodiments.

### List of Reference Signs

- 1: electric switching system
- 21: first branch
- 22: second branch
- 3: control unit
- 41: working semiconductor switch in the first branch
- 42: working semiconductor switch in the second branch
- 43: semiconductor switch in a short-circuit failure mode in the first branch
- 5: semiconductor body
- 51: transistor structure
- 52: diode structure
- 6: hybrid high-voltage direct current breaker
- 61: high-voltage input line
- 62: high-voltage output line
- 71: first electric terminal
- 72: second electric terminal
- 8: modification of the electric switching system
- C: collector electrode
- G: gate electrode
- E: emitter electrode
- S: method step

## Claims

1. An electric switching system (1) comprising a plurality of semiconductor switches (41, 42, 43) and a control unit (3), wherein
- the semiconductor switches (41, 42, 43) each comprise a transistor structure (51) and a diode structure (52) being electrically connected in anti-parallel with each other,
- the semiconductor switches (41, 42, 43) are arranged in a first branch (21) being a series connection of first ones of the semiconductor switches (41, 43) and in a second branch (22) being a series connection of second ones of the semiconductor switches (42), the first branch (21) being electrically connected in parallel with the second branch (22),
and
- in case that a defective one (43) of the first ones of the semiconductor switches (41, 43) is in a short-circuit failure mode, SCFM, the control unit (3) is configured to turn on remaining working ones (41) of the first ones of the semiconductor switches (41, 43) during a reverse current flow direction phase of the electric switching system (1).

2. The electric switching system (1) according to the preceding claim,
wherein the semiconductor switches (41, 42, 43) are bi-mode insulated gate transistors (41, 42, 43), BIGTs.

3. The electric switching system (1) according to any one of the preceding claims,
wherein, during the reverse current flow direction phase, a voltage drop over the first branch (21) is higher than over the second branch (22).

4. The electric switching system (1) according to any one of the preceding claims,
wherein, during a forward current flow direction phase of the electric switching system (1), the control unit (3) is configured to turn off the working ones (41) of the first ones of the semiconductor switches (41, 43).

5. The electric switching system (1) according to any one of the preceding claims,
wherein all the semiconductor switches (41, 42, 43) are of a same type, and
wherein the first branch (21) has a same number of the semiconductor switches (41, 42, 43) as the second branch (22) .

6. The electric switching system (1) according to any one of the preceding claims,
wherein the first branch (21) comprises at least three and at most 20 of the first ones of the semiconductor switches (41, 43) and the second branch (22) comprises at least three and at most 20 of the second ones of the semiconductor switches (42) .

7. The electric switching system (1) according to any one of the preceding claims,
wherein all the second ones of the semiconductor switches (42) are working ones.

8. The electric switching system (1) according to any one of the preceding claims,
wherein a first threshold voltage of the semiconductor switches (41, 42) in a transistor mode is higher than a second threshold voltage of the semiconductor switches (41, 42) in a diode mode except for the defective one (43) of the first ones of the semiconductor switches (41, 43) being in the SCFM.

9. The electric switching system (1) according to the preceding claim,
wherein the first threshold voltage differs from the second threshold voltage by at least a difference factor of 1.4 and at most by a factor of five.

10. The electric switching system (1) according to claim 5 and according to any one of the two preceding claims,
wherein for the first threshold voltage V1, the second threshold voltage V2 and the same number of the semiconductor switches (41, 42, 43) N, the following applies: N > V2/(V2-V1) .

11. The electric switching system (1) according to the preceding claim,
wherein the following applies: N > (V2+X)/(V2-V1) with 1.5 V ≤ X ≤ 8 V.

12. The electric switching system (1) according to the preceding claim,
wherein there are at least two and at most ten of the second branches (22).

13. The electric switching system (1) according to any one of the preceding claims,
which is a load commutation switch, LCS.

14. A hybrid high-voltage direct current breaker (6), HHB, comprising a high-voltage input line (61), a high-voltage output line (62), and the electric switching system (1) according to any one of the preceding claims,
wherein the electric switching system (1) is electrically connected between the high-voltage input line (61) and the high-voltage output line (62).

15. An operating method for the electric switching system (1) according to any one of claims 1 to 13, comprising:
when the electric switching system (1) is in the reverse current flow direction phase, turning on, by the control unit (3), the remaining working ones (41) of the first ones of the semiconductor switches (41, 43),
wherein the defective one (43) of the first ones of the semiconductor switches (41, 43) is in the SCFM.
